# FASCICULE DE BREVET EUROPEEN

(11) **EP 3 429 064 B1**
(45) Date de publication et mention de la délivrance du brevet: **28.10.2020**
(21) Numéro de dépôt: 18182008.5
(22) Date de dépôt: 05.07.2018
(51) Int. Cl.: H02K 3/12, H02K 3/28, H02K 15/085

(54) **PROCÉDÉ DE BOBINAGE AMÉLIORÉ D'UN STATOR DE MACHINE ELECTRIQUE TOURNANTE ET STATOR BOBINÉ CORRESPONDANT**
VERBESSERTES WICKLUNGSVERFAHREN EINES STATORS EINER ELEKTRISCH UMLAUFENDEN MASCHINE, UND MIT ENTSPRECHENDER WICKLUNG VERSEHENER STATOR
IMPROVED WINDING METHOD FOR A STATOR OF A ROTATING ELECTRICAL MACHINE AND CORRESPONDING WOUND STATOR

(30) Priorité: 11.07.2017 FR 1756559
(43) Date de publication de la demande: 16.01.2019
(73) Titulaire: VALEO EQUIPEMENTS ELECTRIQUES MOTEUR, 94046 Créteil Cedex (FR)
(72) Inventeur: WILQUIN, Geoffrey, 62630 ETAPLES SUR MER (FR); DE CLERCQ, Stéphane, 62630 ETAPLES SUR MER (FR); LECLERCQ, Sébastien, 62630 ETAPLES SUR MER (FR)

(56) Documents cités:
- EP-A2- 2 101 397
- WO-A1-2016/139430
- US-A1- 2015 028 713
- US-A1- 2015 054 374
- US-A1- 2017 033 619

## Description

La présente invention porte sur un procédé de bobinage amélioré d'un stator de machine électrique tournante, ainsi que sur le stator bobiné correspondant. L'invention trouve une application particulièrement avantageuse pour un stator d'une machine électrique tournante telle que par exemple un alternateur, un alterno-démarreur, ou un moteur électrique.

De façon connue en soi, les machines électriques tournantes comportent un stator et un rotor solidaire d'un arbre. Le rotor pourra être solidaire d'un arbre menant et/ou mené et pourra appartenir à une machine électrique tournante sous la forme d'un alternateur comme décrit dans le document EP0803962 ou d'un moteur électrique comme décrit dans le document EP0831580. La machine électrique comporte un boîtier portant le stator. Ce boîtier est également configuré pour porter à rotation l'arbre du rotor par exemple par l'intermédiaire de roulements.

Le rotor comporte un corps formé par un empilage de feuilles de tôles maintenues sous forme de paquet au moyen d'un système de fixation adapté, tel que des rivets traversant axialement le rotor de part en part. Le rotor comporte des pôles formés par exemple par des aimants permanents logés dans des cavités ménagées dans la masse magnétique du rotor, comme cela est décrit par exemple dans le document EP0803962. Alternativement, dans une architecture dite à pôles "saillants", les pôles sont formés par des bobines enroulées autour de bras du rotor.

Le stator comporte un corps constitué par un empilage de tôles minces ainsi qu'un bobinage de phases reçu dans des encoches du stator ouvertes vers l'intérieur. Dans les stators d'alternateurs de ce genre, les types de bobinages les plus couramment utilisés sont, d'une part, les bobinages dits "concentriques" constitués par des bobines fermées sur elles-mêmes qui sont enroulées autour des dents du stator, et d'autre part, les bobinages du type dit "ondulé".

Un bobinage ondulé comporte une pluralité d'enroulements de phase, chaque enroulement de phase comportant un conducteur en spirale dont chaque spire forme des ondulations parcourant les encoches du corps. Ainsi, dans chaque spire, le conducteur présente des structures de boucle situées alternativement de chaque côté du stator reliant entre eux des structures de segment situés à l'intérieur des encoches du stator. Le conducteur pourra être formé d'un ou plusieurs fils électriquement conducteur.

Le document FR3033456 enseigne la mise en œuvre d'un procédé de bobinage dans lequel l'injection des systèmes triphasés dans la première spire et l'arrêt du bobinage des systèmes triphasés dans la dernière spire sont décalés de façon à respecter la position des entrées et des sorties de phases par rapport au positionnement de l'électronique de commande de la machine électrique tournante.

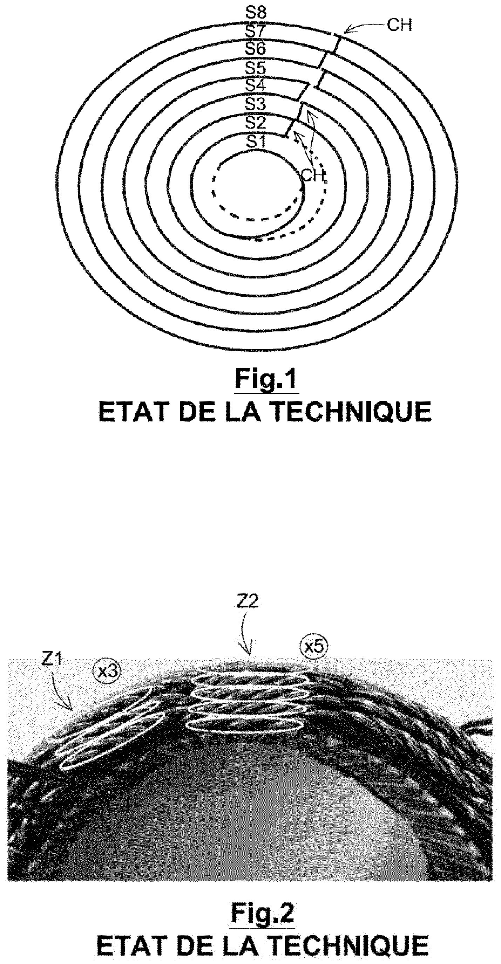

Comme cela est illustré sur la figure 1, l'inversion de sens de rotation CH d'une spire S1-S8 à l'autre est effectuée à la même position angulaire du stator. Toutefois, pour les stators ayant un nombre impair de conducteurs par encoche des surépaisseurs sont présentes sur le chignon entre les 2 systèmes de phases. Pour un stator de n spires, le chignon aura des couches apparentes de (n-1)/2 spires et de [((n+1)/2)+1] spires. Ainsi, tel que cela est illustré sur la figure 2, pour un stator comportant 7 conducteurs par encoche, on observe entre les 2 systèmes de phases des zones Z1 à trois couches de spires et des zones Z2 à cinq couches de spires, ce qui engendre un encombrement important.

L'invention vise à remédier efficacement à cet inconvénient en proposant un procédé de bobinage d'un stator pour une machine électrique tournante polyphasée,
- ledit stator comportant des encoches destinées à recevoir chacune un nombre impair de conducteurs d'un bobinage,
- ledit bobinage comprenant deux systèmes comprenant chacun un groupe de conducteurs respectifs,
- ledit procédé comprend des étapes d'installation des conducteurs dans lesdites encoches répétées de façon à former un bobinage comprenant une pluralité de spires réalisées alternativement suivant un premier sens de rotation et suivant un deuxième sens de rotation opposé au premier sens de rotation, caractérisé en ce qu'au moins deux changements de sens de rotation d'une spire à l'autre sont effectués dans des zones angulaires différentes.

L'invention permet ainsi, en inversant la rotation de bobinage pour le réparti de manière non conventionnelle, d'obtenir des chignons de bobinage ayant une épaisseur homogène. Dans ce cas, pour un stator ayant un nombre n impair de conducteurs par encoche, le chignon aura des couches apparentes de (n+1)/2 spires entre les deux systèmes de phases.

Selon une mise en œuvre, certaines spires, notamment des spires impaires, situées entre une première spire et une dernière spire s'étendent sur moins de 360 degrés.

Selon une mise en œuvre, certaines spires, notamment des spires paires, situées entre une première spire et une dernière spire s'étendent sur 360 degrés.

Selon une mise en œuvre, ledit procédé comporte une étape de réalisation d'une première spire dans laquelle le commencement de l'installation des conducteurs du deuxième système est décalé par rapport au commencement de l'installation des conducteurs du premier système.

Selon une mise en œuvre, le décalage angulaire entre le commencement de l'installation des conducteurs du deuxième système et le commencement de l'installation des conducteurs du premier système **dépend d'un positionnement d'une électronique de commande.**

Selon une mise en œuvre, ledit procédé comporte une étape de réalisation d'une dernière spire dans laquelle l'arrêt de l'installation des conducteurs du deuxième système est décalé par rapport à l'arrêt de l'installation des conducteurs du premier système.

Selon une mise en œuvre, le décalage angulaire entre l'arrêt de l'installation des conducteurs du deuxième système et l'arrêt de l'installation des conducteurs du premier système triphasé **dépend d'un positionnement d'une électronique de commande.**

Selon une mise en œuvre, les conducteurs du premier système et les conducteurs du deuxième système sont bobinés dans un premier temps sur une broche puis transférés sur un corps de stator. Toutefois, en variante, il est possible de bobiner directement dans le corps du stator.

Selon une mise en œuvre, le premier système et le deuxième système sont de type triphasé.

Selon une mise en œuvre, chaque conducteur est formé par un ou plusieurs fils électriquement conducteur, notamment deux fils.

L'invention a également pour objet un stator pour une machine électrique tournante polyphasée comportant des encoches destinées à recevoir chacune un nombre impair de conducteurs d'un bobinage,
- ledit bobinage comprenant deux systèmes comprenant chacun un groupe de conducteurs respectifs,
- ledit bobinage comprenant une pluralité de spires réalisées alternativement suivant un premier sens de rotation puis suivant un deuxième sens de rotation opposé au premier sens de rotation,
caractérisé en ce qu'au moins deux changements de sens de rotation d'une spire à l'autre sont situés dans des zones angulaires différentes.

L'invention sera mieux comprise à la lecture de la description qui suit et à l'examen des figures qui l'accompagnent. Ces figures ne sont données qu'à titre illustratif mais nullement limitatif de l'invention.
La figure 1, déjà décrite, est une représentation du positionnement angulaire des différents changements de sens de rotation pour la réalisation des spires lors de mise en œuvre d'un procédé de bobinage classique avec un nombre de conducteurs par encoches pair;
La figure 2, déjà décrite, est une vue de dessus d'un stator illustrant la configuration des chignons pour un bobinage ayant un nombre de conducteurs par encoche impair et obtenu par un procédé de bobinage classique;
La figure 3 est une vue en perspective d'un stator bobiné obtenu suite à la mise en œuvre du procédé de bobinage selon la présente invention;
Les figures 4a à 4i illustrent, pour une broche représentée en projection à plat, les différentes spires réalisées lors de la mise en œuvre du procédé de bobinage selon la présente invention;
La figure 5 illustre le couplage des deux systèmes triphasés obtenus suite à la mise en œuvre du procédé selon la présente invention;
La figure 6 est une représentation schématique du positionnement angulaire des différents changements de sens de rotation des spires lors d'une mise en œuvre d'un procédé de bobinage selon l'invention;
La figure 7 est une vue de dessus d'un stator illustrant la configuration des chignons pour un bobinage ayant un nombre de spires impair et obtenu avec le procédé de bobinage selon l'invention;
**La** **figure 8** **est une représentation schématique du positionnement angulaire des différents changements de sens de rotation des spires lors d'une variante de mise en œuvre du procédé de bobinage selon l'invention.**

Les éléments identiques, similaires, ou analogues conservent la même référence d'une figure à l'autre.

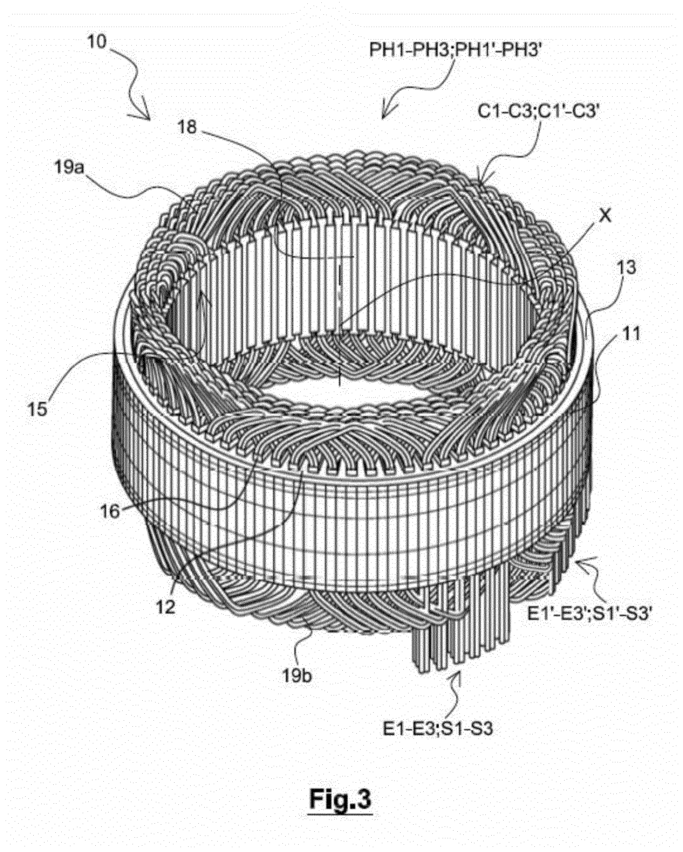

La figure 3 est une vue en perspective d'un stator bobiné 10 de machine électrique tournante qui comporte principalement un corps 11 dans lequel sont montés plusieurs enroulements de phase PH1-PH3; PH1'-PH3' formant un bobinage. La machine électrique est par exemple un alternateur ou un alterno-démarreur. Cette machine électrique est de préférence destinée à être mise en œuvre dans un véhicule automobile. On rappelle qu'un alterno-démarreur est une machine électrique apte à travailler de manière réversible, d'une part, comme générateur électrique en fonction alternateur, et d'autre part comme moteur électrique, notamment pour démarrer le moteur thermique du véhicule automobile.

Le corps de stator 11 a une forme cylindrique annulaire d'axe X et consiste en un empilement axial de tôles planes. Le corps 11 comporte des dents 12 réparties angulairement de manière régulière sur une circonférence interne d'une culasse 13. Ces dents 12 délimitent deux à deux des encoches 15. La culasse 13 correspond à la portion annulaire pleine du corps 11 qui s'étend entre le fond des encoches 15 et la périphérie externe du corps 11.

Les encoches 15 débouchent axialement de part et d'autre du corps 11. Les encoches 15 sont également ouvertes radialement dans la face interne du corps 11. Les encoches 15 sont de préférence à bords parallèles, c'est-à-dire que les faces internes en vis-à-vis l'une de l'autre sont parallèles entre elles. Les encoches 15 sont par exemple au nombre de 36, 48, 60, 72, 84, ou 96. Dans l'exemple de réalisation, le stator 10 comporte 72 encoches. De préférence, le stator 10 comporte des pieds de dent afin de pouvoir fermer les encoches à l'aide de cales retenues radialement par les pieds de dent. Des isolants 16 sont disposés dans les encoches 15 du stator.

Pour former le bobinage du stator 10, plusieurs enroulements de phase PH1-PH3, PH1'-PH3' sont installés dans les encoches 15 du corps 11. En l'occurrence, le stator "hexaphasé" comporte six enroulements de phase pour former deux systèmes triphasés couplés entre eux. L'invention est cependant applicable à des stators comportant un nombre plus grand de systèmes triphasés ou à des systèmes comportant chacun un nombre d'enroulements de phase différent de trois.

Chaque enroulement de phase PH1-PH3, PH1'-PH3' est constitué par un conducteur C1-C3, C1'-C3' plié en forme de serpentin et enroulé à l'intérieur du stator dans les encoches 15 pour former des spires, l'enroulement de plusieurs spires réalisant le bobinage de la phase complète. Une spire correspond à la portion du bobinage entre deux changements de sens de rotation ou à la portion entre les entrées de phase et le premier changement de sens de rotation ou à la portion entre le dernier changement de sens de rotation et les sorties de phase.

Chaque encoche 15 reçoit plusieurs fois le conducteur C1-C3, C1'-C3' d'une même phase, ainsi lorsqu'il y a N enroulements de phase le conducteur d'un même enroulement de phase PH1-PH3, PH1'-PH3' est inséré toutes les N encoches 15.

Dans chaque spire, le conducteur C1-C3, C1'-C3' présente des structures de boucle 19a, 19b situées alternativement de chaque côté du stator reliant entre eux des structures de segment 18 situées dans une série d'encoches 15 associées à un enroulement de phase donné. Il est à noter que chaque conducteur C1-C3, C1'-C3' pourra comporter un faisceau de M fils conducteurs, M étant de préférence supérieur ou égal à 2. En variante, chaque conducteur C1-C3, C1'-C3' est constitué par un seul fil. En l'occurrence les fils présentent une section ronde. Alternativement, afin d'optimiser le remplissage des encoches 15, les fils pourront présenter une section rectangulaire ou carrée. Les conducteurs sont de préférence réalisés en cuivre recouvert d'émail.

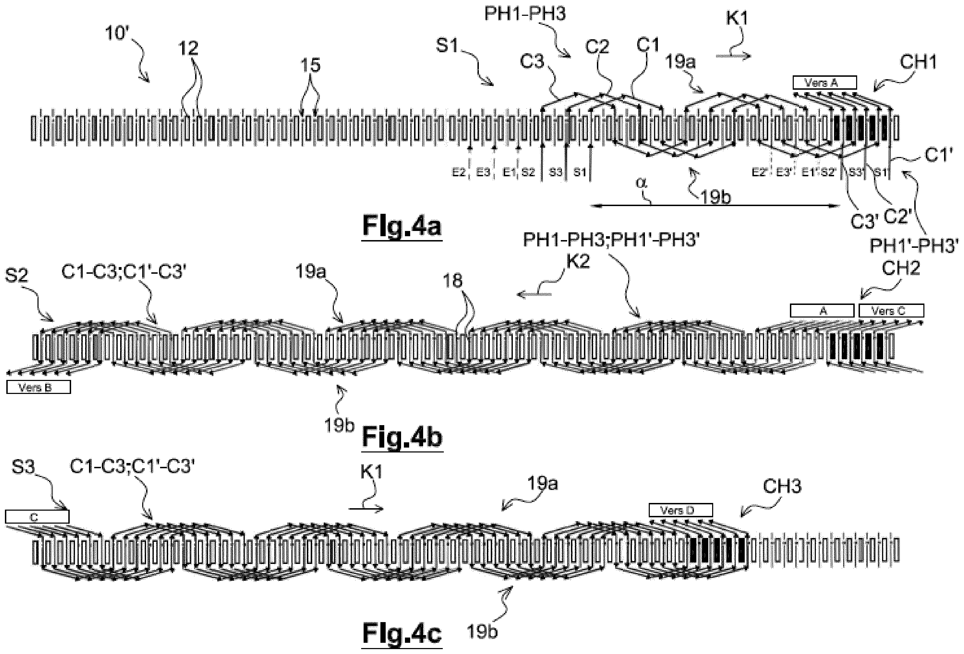

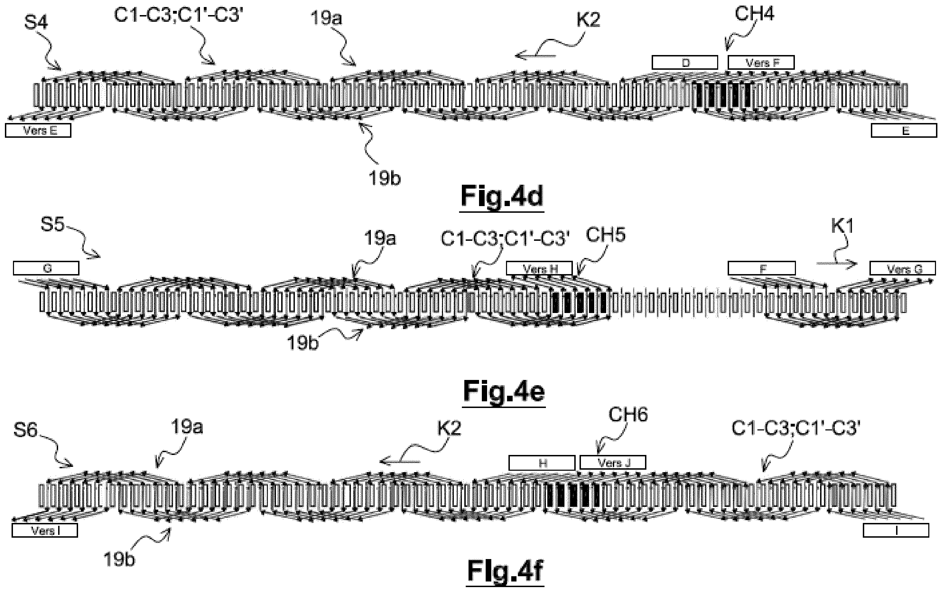

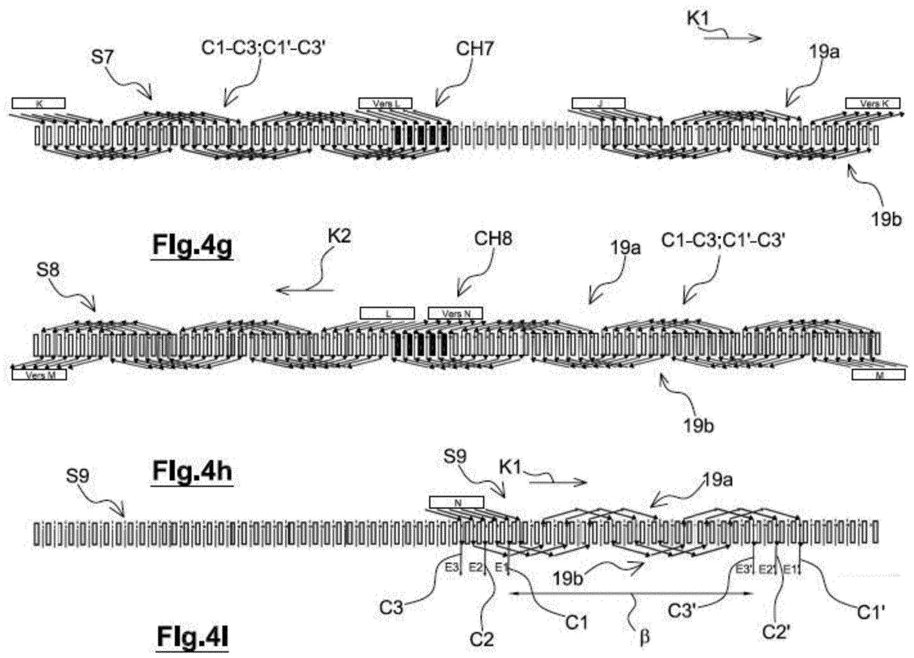

On décrit ci-après, en référence avec les figures 4a à 4i, le procédé permettant d'obtenir le stator bobiné 10 hexaphasé comportant un premier système triphasé formé par les enroulements de phase PH1-PH3 et un deuxième système triphasé formé par les enroulements PH1'-PH3'. Chaque enroulement de phase PH1-PH3, PH1'-PH3' est constitué par un conducteur C1-C3, C1'-C3' bobiné correspondant. En l'occurrence, les conducteurs C1-C3, C1'-C3' comportent chacun un faisceau de 2 fils, même si un seul fil par conducteur a été représenté sur les figures pour faciliter la compréhension du procédé.

Plus précisément, comme cela est illustré sur la figure 4a, on réalise une première étape d'installation des conducteurs C1-C3 du premier système de manière à former une première spire S1, dite spire de démarrage. A cet effet, les conducteurs C1-C3 sont insérés dans trois encoches 15 distinctes correspondant au premier système A. Deux encoches adjacentes 15 de cet ensemble sont espacées entre elles par une encoche laissée libre afin de permettre l'insertion ultérieure des conducteurs C1'-C3' du deuxième système triphasé B, comme cela est expliqué ci-après.

Les extrémités des conducteurs C1-C3 de la spire de démarrage correspondent par exemple aux sorties S1-S3 du bobinage du premier système.

Les conducteurs C1-C3 du premier système sont ensuite pliés pour former des structures de boucles 19a, ici de forme sensiblement triangulaire, qui dépassent d'un même côté du stator 10. Les conducteurs C1-C3 du premier système A sont ensuite insérés chacun dans l'encoche 15 suivante qui est située N encoches après la première (ici N=6). Les conducteurs C1-C3 sont ensuite pliés pour former des structures de boucle 19b qui dépassent d'un côté opposé à celui des premières structures boucles 19a. Ainsi, les structures de boucle 19a, 19b sont situées à l'extérieur du stator 10 alternativement d'un côté ou de l'autre du stator, l'ensemble des structures de boucles 19a, 19b dépassant d'un même côté du stator 10 formant un chignon de bobinage.

On continue ainsi à former le bobinage du premier système PH1-PH3 seul jusqu'à ce qu'un nombre d'encoches correspondant à un angle a prédéterminé du stator 10 soit couvert. Cet angle α est prédéterminé de telle façon que **les sorties des deux systèmes triphasés se situent respectivement en face de l'électronique de commande correspondante.**

Lorsque cet angle α prédéterminé est atteint, par exemple un angle α de l'ordre de 120 degrés, on réalise l'installation des conducteurs C1'-C3' du deuxième système triphasé. A cet effet, les portions des conducteurs C1'-C3' du deuxième système, correspondant par exemple aux sorties S1'-S3', sont insérés dans les encoches 15 libres situées entre les encoches remplies par le premier système A ainsi que dans une encoche adjacente 15, de manière à avoir alternativement une encoche 15 recevant un conducteur d'un des systèmes PH1-PH3 puis une encoche 15 recevant un conducteur de l'autre système PH1'-PH3'.

On réalise ensuite le bobinage simultané des deux systèmes triphasés. Autrement dit, on réalise le bobinage simultané et en parallèle des N conducteurs C1-C3, C1'-C3' dans des séries successives de N encoches 15 (N étant ici égal à 6).

Le bobinage de la spire démarrage S1 ayant été effectuée dans un premier sens K1, on effectue un changement de sens CH1 pour passer dans un deuxième sens de bobinage K2 afin de réaliser une deuxième spire S2, comme cela est illustré par la figure 4b. Les deux systèmes sont alors bobinés simultanément dans la spire S2 suivant un tour, c'est-à-dire que toutes les encoches 15 de la broche sont remplies successivement par série de N encoches par les deux systèmes suivant le sens K2.

Lorsque la deuxième spire S2 est terminée, on effectue un changement de sens CH2 pour repasser dans le sens de bobinage K1 afin de réaliser une troisième spire S3, comme cela est illustré sur la figure 4c. Les deux systèmes sont alors bobinés simultanément dans la spire S3 suivant moins d'un tour complet du stator 10, c'est-à-dire suivant moins de 360 degrés (cf. figure 4c).

Il est à noter que lors d'une phase de bobinage en sens inverse, chaque structure de boucle 19a, 19b d'un conducteur C1-C3, C1'-C3' appartenant à un enroulement PH1-PH3, PH1'-PH3' donné va se placer dans l'espace libre entre deux structures de boucle 19a, 19b du conducteurs C1-C3, C1'-C3' obtenues lors de la phase de bobinage dans le premier sens. On obtient ainsi un bobinage symétrique de type ondulé réparti.

Lorsque la troisième spire S3 est terminée, on réalise un nouveau changement de sens CH3 pour réaliser une quatrième spire S4, tel que montré sur la figure 4d. Les étapes sont répétées pour réaliser les spires S5 à S8 avec les changements de sens de rotation correspondants CH5 à CH8 (cf. figures 4e à 4h).

Les spires impaires S3, S5, S7 situées entre la première spire S1 et la dernière spire S9 s'étendent sur moins de 360 degrés, tandis que les spires paires S2, S4, S6, S8 situées entre la première spire S1 et la dernière spire S9 s'étendent sur 360 degrés.

Après avoir réalisé un dernier changement de sens CH8, on réalise, comme cela est illustré par la figure 4i, une dernière spire S9 dans laquelle l'arrêt de l'installation des conducteurs C1-C3 du premier système triphasé est décalé par rapport à l'arrêt de l'installation des conducteurs C1'-C3' du deuxième système triphasé. Les extrémités des conducteurs C1-C3, C1'-C3' de la dernière spire S9 correspondent respectivement par exemple aux entrées E1-E3 du bobinage du premier système PH1-PH3 et aux entrées E1'-E3' du bobinage du deuxième système PH1'-PH3'. Avantageusement, le décalage angulaire β entre l'arrêt de l'installation des conducteurs C1'-C3' du deuxième système et l'arrêt de l'installation des conducteurs C1-C3 du premier système triphasé **dépend du positionnement de l'électronique de commande. En effet, ce décalage angulaire β est prédéterminé de telle façon que les entrées des deux systèmes triphasés se situent respectivement en face de l'électronique de commande correspondante. Ce décalage angulaire β vaut par exemple 120 degrés.**

Comme cela est illustré par les figures 4a-4i, 6, et 8 au moins deux changements de sens de rotation CH1-CH8 d'une spire à l'autre sont effectués dans des zones angulaires différentes. Par "zones angulaires différentes", on entend le fait que tous les conducteurs C1-C3, C1'-C3' d'une zone de changement de sens de rotation sont situés dans des encoches 15 qui sont différentes des encoches d'une autre zone de changement de sens de rotation. Il n'y a donc aucune superposition entre les encoches 15 des deux zones angulaires différentes de changements de sens de rotation.

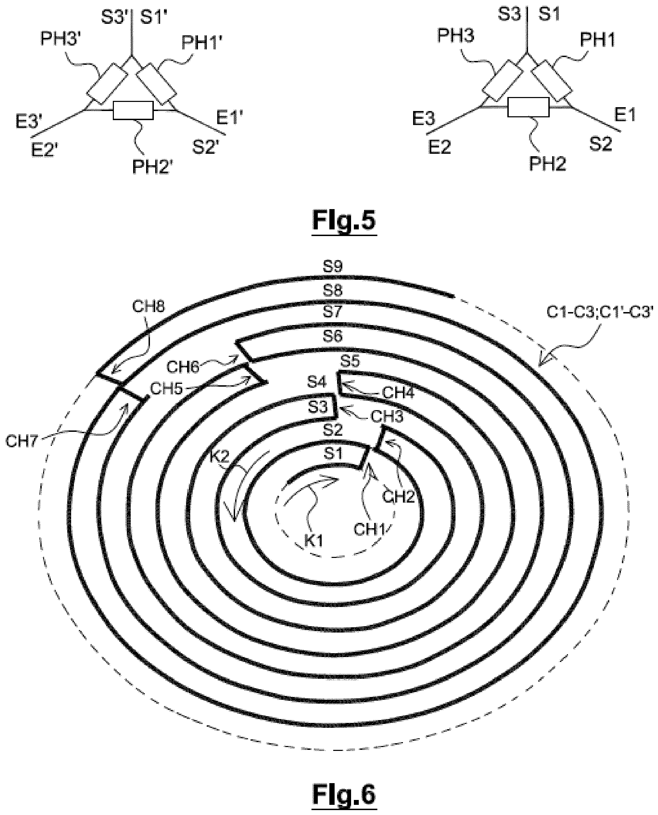

**Dans l'exemple de réalisation de la** **figure 6****, les changements de sens de rotation du bobinage CH1 et CH2 sont réalisés dans une première zone angulaire. Les changements de sens de rotation du bobinage CH3 et CH4 sont situés dans une deuxième zone angulaire. Les changements de sens de rotation du bobinage CH5 et CH6 sont situés dans une troisième zone angulaire. Les changements de sens de rotation du bobinage CH7 et CH8 sont situés dans une quatrième zone angulaire. Ces quatre zones angulaires sont différentes les unes par rapport aux autres. Deux zones angulaires adjacentes sont espacées entre elles d'un angle inférieur à 180 degrés.**

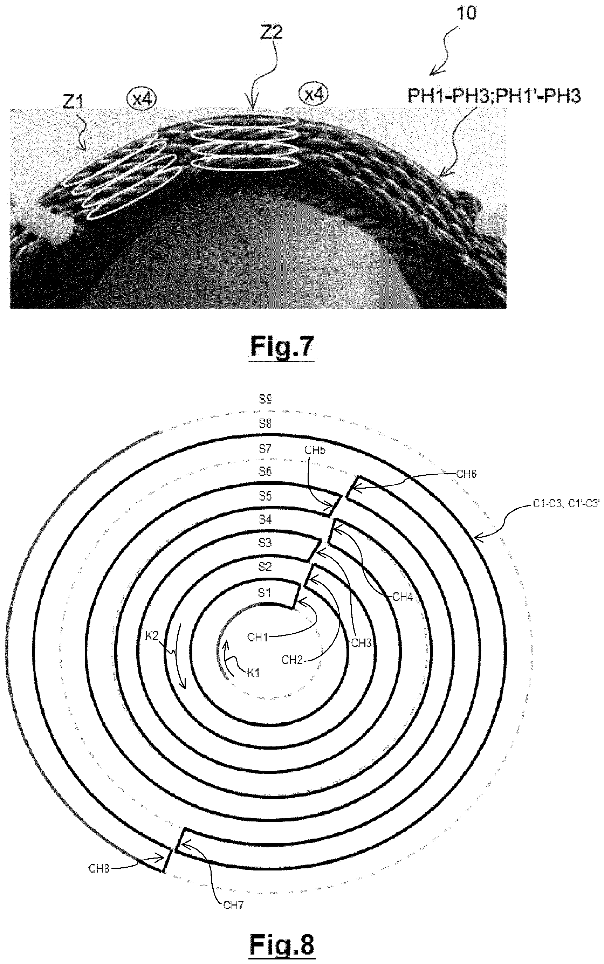

**Dans l'exemple de réalisation de la** **figure 8****, les changements de sens de rotation du bobinage CH1 à CH6 sont réalisés dans une première zone angulaire; tandis que les changements de sens de rotation du bobinage CH7 et CH8 sont situés dans une deuxième zone angulaire différente de la première zone angulaire. Ces deux zones angulaires sont espacées entre elles d'un angle de l'ordre de 180 degrés.**

Comme cela est illustré par la figure 7, l'invention permet ainsi, en inversant la rotation de bobinage pour le réparti de manière non conventionnelle, d'obtenir des chignons de bobinage ayant une épaisseur homogène. Dans ce cas, pour un stator ayant un nombre n impair de spires, le chignon aura des couches apparentes de (n+1)/2 spires entre les deux systèmes de phases. Pour un stator comportant 7 conducteurs par encoche, la moyenne des couches apparentes dans les zones Z1 et Z2 vaut donc 4.

A la fin du procédé, les entrées E1-E3, E1'-E3' et les sorties S1-S3, S1'-S3' de chaque système sont regroupées entre elles dans un même secteur angulaire, en sorte qu'il est possible de réaliser aisément le couplage en triangle de chacun des systèmes triphasés, tel que montré sur la figure 5.

A cet effet, dans le premier système PH1-PH3, l'entrée E1 du premier enroulement de phase PH1 est connectée à la sortie S2 du deuxième enroulement de phase PH2, la sortie S1 du premier enroulement de phase PH1 est connectée à la sortie S3 du troisième enroulement de phase PH3, et l'entrée E2 du deuxième enroulement de phase PH2 est connectée à l'entrée E3 du troisième enroulement de phase PH3.

Par ailleurs, dans le deuxième système PH1'-PH3', l'entrée E1' du premier enroulement de phase PH1' est connectée à la sortie S2' du deuxième enroulement de phase PH2', la sortie S1' du premier enroulement de phase PH1' est connectée à la sortie S3' du troisième enroulement de phase PH3', et l'entrée E2' du deuxième enroulement de phase PH2' est connectée à l'entrée E3' du troisième enroulement de phase PH3'.

Avantageusement, les conducteurs C1-C3, C1'-C3' du premier système PH1-PH3 et du deuxième système PH1'-PH3' sont bobinés dans un premier temps sur une broche 10' puis transférés sur le corps de stator 11. En variante, le bobinage peut être réalisé in situ directement sur le corps de stator 11.

En variante, les systèmes triphasés PH1-PH3; PH1'-PH3' pourront être couplés en étoile.

Bien entendu, la description qui précède a été donnée à titre d'exemple uniquement et ne limite pas le domaine de l'invention dont on ne sortirait pas en remplaçant les différents éléments ou étapes par tous autres équivalents.

## Revendications

1. Procédé de bobinage d'un stator (10) pour une machine électrique tournante polyphasée,
- ledit stator (10) comportant des encoches (15) destinées à recevoir chacune un nombre impair de conducteurs d'un bobinage, du type ondulé,
- ledit bobinage comprenant deux systèmes de phases (PH1-PH3, PH1'-PH3') comprenant chacun un groupe de conducteurs respectifs (C1-C3, C1'-C3'),
- ledit procédé comprend des étapes d'installation des conducteurs (C1-C3, C1'-C3') dans lesdites encoches (15) répétées de façon à former un bobinage comprenant une pluralité de spires (S1-S9) réalisées alternativement suivant un premier sens de rotation (K1) et suivant un deuxième sens de rotation (K2) opposé au premier sens de rotation,
**caractérisé en ce qu'**au moins deux changements de sens de rotation (CH1-CH8) d'une spire à l'autre sont effectués dans des zones angulaires différentes, permettant ainsi d'obtenir des chignons de bobinage ayant une épaisseur homogène.

2. Procédé selon la revendication 1, **caractérisé en ce que** certaines spires, notamment des spires impaires (S3, S5, S7), situées entre une première spire (S1) et une dernière spire (S9) s'étendent sur moins de 360 degrés.

3. Procédé selon la revendication 1 ou 2, **caractérisé en ce que** certaines spires, notamment des spires paires (S2, S4, S6, S8), situées entre une première spire (S1) et une dernière spire (S9) s'étendent sur 360 degrés.

4. Procédé selon l'une quelconque des revendications 1 à 3, **caractérisé en ce qu'**il comporte une étape de réalisation d'une première spire (S1) dans laquelle le commencement de l'installation des conducteurs (C1'-C3') du deuxième système est décalé par rapport au commencement de l'installation des conducteurs (C1-C3) du premier système.

5. Procédé selon la revendication 4, **caractérisé en ce que** le décalage angulaire (α) entre le commencement de l'installation des conducteurs (C1'-C3') du deuxième système et le commencement de l'installation des conducteurs (C1-C3) du premier système **dépend d'un positionnement d'une électronique de commande.**

6. Procédé selon l'une quelconque des revendications 1 à 5, **caractérisé en ce qu'**il comporte une étape de réalisation d'une dernière spire (S9) dans laquelle l'arrêt de l'installation des conducteurs (C1'-C3') du deuxième système est décalé par rapport à l'arrêt de l'installation des conducteurs (C1-C3) du premier système.

7. Procédé selon la revendication 6, **caractérisé en ce que** le décalage angulaire (β) entre l'arrêt de l'installation des conducteurs (C1'-C3') du deuxième système et l'arrêt de l'installation des conducteurs (C1-C3) du premier système triphasé **dépend d'un positionnement d'une électronique de commande.**

8. Procédé selon l'une quelconque des revendications 1 à 7, **caractérisé en ce que** les conducteurs (C1-C3) du premier système et les conducteurs (C1'-C3') du deuxième système sont bobinés dans un premier temps sur une broche (10') puis transférés sur un corps de stator (11).

9. Procédé selon l'une quelconque des revendications 1 à 8, **caractérisé en ce que** le premier système (PH1-PH3) et le deuxième système (PH1'-PH3') sont de type triphasé.

10. Procédé selon l'une quelconque des revendications 1 à 9, **caractérisé en ce que** chaque conducteur (C1-C3; C1'-C3') est formé par un ou plusieurs fils électriquement conducteur, notamment deux fils.

11. Stator (10) pour une machine électrique tournante polyphasée comportant des encoches (15) destinées à recevoir chacune un nombre impair de conducteurs d'un bobinage, du type ondulé,
- ledit bobinage comprenant deux systèmes de phases (PH1-PH3; PH1'-PH3') comprenant chacun un groupe de conducteurs respectifs (C1-C3, C1'-C3'),
- ledit bobinage comprenant une pluralité de spires (S1-S9) réalisées alternativement suivant un premier sens de rotation (K1) puis suivant un deuxième sens de rotation (K2) opposé au premier sens de rotation,
**caractérisé en ce qu'**au moins deux changements de sens de rotation (CH1-CH8) d'une spire à l'autre sont situés dans des zones angulaires différentes, permettant ainsi d'obtenir des chignons de bobinage ayant une épaisseur homogène.

## Patentansprüche

1. Verfahren zur Wicklung eines Stators (10) für eine mehrphasige drehende elektrische Maschine,
- wobei der Stator (10) Nuten (15) aufweist, die dazu bestimmt sind, jeweils eine ungerade Anzahl von Leitern einer Wicklung vom wellenförmigen Typ aufzunehmen,
- wobei die Wicklung zwei Phasensysteme (PH1-PH3, PH1'-PH3') umfasst, die jeweils eine Gruppe von jeweiligen Leitern (C1-C3, C1'-C3') umfassen,
- das Verfahren umfasst Schritte des Einsetzens der Leiter (C1-C3, C1'-C3') in die Nuten (15), die wiederholt werden, um eine Wicklung zu bilden, die eine Mehrzahl von Windungen (S1-S9) umfassen, die abwechselnd in einer ersten Drehrichtung (K1) und in einer zweiten Drehrichtung (K2), die der ersten Drehrichtung entgegengesetzt ist, ausgebildet sind,
**dadurch gekennzeichnet, dass** wenigstens zwei Drehrichtungsänderungen (CH1-CH8) von einer Windung zur anderen in verschiedenen Winkelbereichen vorgenommen werden, wodurch ermöglicht wird, Wickelköpfe mit einer homogenen Dicke zu erhalten.

2. Verfahren nach Anspruch 1, **dadurch gekennzeichnet, dass** bestimmte Windungen, insbesondere ungerade Windungen (S3, S5, S7), die sich zwischen einer ersten Windung (S1) und einer letzten Windung (S9) befinden, über weniger als 360 Grad erstrecken.

3. Verfahren nach Anspruch 1 oder 2, **dadurch gekennzeichnet, dass** bestimmte Windungen, insbesondere gerade Windungen (S2, S4, S6, S8), die sich zwischen einer ersten Windung (S1) und einer letzten Windung (S9) befinden, über 360 Grad erstrecken.

4. Verfahren nach einem der Ansprüche 1 bis 3, **dadurch gekennzeichnet, dass** es einen Schritt des Bildens einer ersten Windung (S1) aufweist, wobei der Beginn des Einsetzens der Leiter (C1'-C3') des zweiten Systems bezogen auf den Beginn des Einsetzens der Leiter (C1-C3) des ersten Systems versetzt ist.

5. Verfahren nach Anspruch 4, **dadurch gekennzeichnet, dass** der Winkelversatz (α) zwischen dem Beginn des Einsetzens der Leiter (C1'-C3') des zweiten Systems und dem Beginn des Einsetzens der Leiter (C1-C3) des ersten Systems **von einer Positionierung einer Steuerungselektronik abhängt.**

6. Verfahren nach einem der Ansprüche 1 bis 5, **dadurch gekennzeichnet, dass** es einen Schritt des Bildens einer letzten Windung (S9) aufweist, wobei die Beendigung des Einsetzens der Leiter (C1'-C3') des zweiten Systems bezogen auf die Beendigung des Einsetzens der Leiter (C1-C3) des ersten Systems versetzt ist.

7. Verfahren nach Anspruch 6, **dadurch gekennzeichnet, dass** der Winkelversatz (β) zwischen der Beendigung des Einsetzens der Leiter (C1'-C3') des zweiten Systems und der Beendigung des Einsetzens der Leiter (C1-C3) des ersten dreiphasigen Systems **von einer Positionierung einer Steuerungselektronik abhängt.**

8. Verfahren nach einem der Ansprüche 1 bis 7, **dadurch gekennzeichnet, dass** die Leiter (C1-C3) des ersten Systems und die Leiter (C1' - C3') des zweiten Systems zuerst auf eine Spindel (10') gewickelt und dann auf einen Statorkörper (11) übertragen werden.

9. Verfahren nach einem der Ansprüche 1 bis 8, **dadurch gekennzeichnet, dass** das erste System (PH1-PH3) und das zweite System (PH1'-PH3') vom dreiphasigen Typ sind.

10. Verfahren nach einem der Ansprüche 1 bis 9, **dadurch gekennzeichnet, dass** jeder Leiter (C1-C3; C1'-C3') von einem oder mehreren elektrisch leitenden Drähten, insbesondere zwei Drähten, gebildet ist.

11. Stator (10) für eine mehrphasige drehende elektrische Maschine, aufweisend Nuten (15), die dazu bestimmt sind, jeweils eine ungerade Anzahl von Leitern einer Wicklung vom wellenförmigen Typ aufzunehmen,
- wobei die Wicklung zwei Phasensysteme (PH1-PH3; PH1'-PH3') umfasst, die jeweils eine Gruppe von jeweiligen Leitern (C1-C3, C1'-C3') umfassen,
- die Wicklung umfassend eine Mehrzahl von Windungen (S1-S9), die abwechselnd in einer ersten Drehrichtung (K1), dann in einer zweiten Drehrichtung (K2), die der ersten Drehrichtung entgegengesetzt ist, ausgebildet sind,
**dadurch gekennzeichnet, dass** sich wenigstens zwei Drehrichtungsänderungen (CH1-CH8) von einer Windung zur anderen in verschiedenen Winkelbereichen befinden, wodurch ermöglicht wird, Wickelköpfe mit einer homogenen Dicke zu erhalten.

## Claims

1. Method for winding a stator (10) for a polyphase rotating electrical machine,
- said stator (10) comprising notches (15) intended to each receive an odd number of conductors of a winding, of wave winding type,
- said winding comprising two systems of phases (PH1-PH3, PH1'-PH3') each comprising a group of respective conductors (C1-C3, C1'-C3'),
- said method comprises steps of installation of the conductors (C1-C3, C1'-C3') in said notches (15) that are repeated so as to form a winding comprising a plurality of turns (S1-S9) produced alternately in a first direction of rotation (K1) and in a second direction of rotation (K2) opposite the first direction of rotation,
**characterized in that** at least two changes of direction of rotation (CH1-CH8) from one turn to another are performed in different angular zones, thus making it possible to obtain winding heads that have a uniform thickness.

2. Method according to Claim 1, **characterized in that** some turns, notably odd turns (S3, S5, S7), situated between a first turn (S1) and a last turn (S9), extend over less than 360°.

3. Method according to Claim 1 or 2, **characterized in that** some turns, notably even turns (S2, S4, S6, S8), situated between a first turn (S1) and a last turn (S9), extend over 360°.

4. Method according to any one of Claims 1 to 3, **characterized in that** it comprises a step of production of a first turn (S1) in which the commencement of the installation of the conductors (C1'-C3') of the second system is staggered relative to the commencement of the installation of the conductors (C1-C3) of the first system.

5. Method according to Claim 4, **characterized in that** the angular offset (α) between the commencement of the installation of the conductors (C1'-C3') of the second system and the commencement of the installation of the conductors (C1-C3) of the first system depends on a positioning of control electronics.

6. Method according to any one of Claims 1 to 5, **characterized in that** it comprises a step of production of a last turn (S9) in which the stopping of the installation of the conductors (C1'-C3') of the second system is offset relative to the stopping of the installation of the conductors (C1-C3) of the first system.

7. Method according to Claim 6, **characterized in that** the angular offset (β) between the stopping of the installation of the conductors (C1'-C3') of the second system and the stopping of the installation of the conductors (C1-C3) of the three-phase first system depends on a positioning of control electronics.

8. Method according to any one of Claims 1 to 7, **characterized in that** the conductors (C1-C3) of the first system and the conductors (C1'-C3') of the second system are wound initially on a pin (10') then transferred onto a stator body (11).

9. Method according to any one of Claims 1 to 8, **characterized in that** the first system (PH1-PH3) and the second system (PH1'-PH3') are of three-phase type.

10. Method according to any one of Claims 1 to 9, **characterized in that** each conductor (C1-C3; C1'-C3') is formed by one or more electrically conductive wires, notably two wires.

11. Stator (10) for a polyphase rotating electrical machine comprising notches (15) intended to each receive an odd number of conductors of a winding, of wavy type,
- said winding comprising two systems of phases (PH1-PH3; PH1'-PH3') each comprising a group of respective conductors (C1-C3, C1'-C3'),
- said winding comprising a plurality of turns (Sl-S9) produced alternately in a first direction of rotation (K1) and then in a second direction of rotation (K2) opposite the first direction of rotation,
**characterized in that** at least two changes of direction of rotation (CH1-CH8) from one turn to another are situated in different angular zones, thus making it possible to obtain winding heads having a uniform thickness.
